# EUROPEAN PATENT APPLICATION

(11) **EP 2 549 327 A1**
(43) Date of publication of application: **23.01.2013**
(21) Application number: 11756096.1
(22) Date of filing: 04.03.2011
(51) Int. Cl.: G02F 1/37, H01S 5/062

(54) **LASER SYSTEM**

(30) Priority: 18.03.2010 JP 2010063111
(71) Applicant: QD Laser, Inc., Kanagawa 210-0855 (JP)
(72) Inventor: YOKOYAMA, Yoshitaka, Kawasaki-shi Kanagawa 210-0855 (JP)
(74) Representative: Hutchison, James
(86) International application number: PCT/JP2011/055016
(87) International publication number: WO 2011/114907

(57) **Abstract**

A laser system 100 includes: a laser module 10 including: a DFB laser 12 that oscillates a laser beam 24; a heater 14 that adjusts a temperature of the DFB laser 12; and a harmonic generation element 18 that converts the laser beam 24 into a harmonic beam 34 of the laser beam 24; and a control unit 40 that modulates a wavelength of the laser beam 24, detects a detection signal synchronized with a modulation signal used for the modulation from an intensity of the harmonic beam 34, and controls a value of a heater current 28 to be injected to the heater 14 so as to reduce an amplitude of the detection signal.

## Description

### TECHNICAL FIELD

The present invention relates to a laser system, and more particularly to a laser system emitting a harmonic beam of a laser beam.

### BACKGROUND ART

Recently, a laser system outputting a laser beam is used in various fields. Especially, a semiconductor laser is used for a low-cost laser system. However, in the semiconductor laser, there is a beam (e.g. a green beam) of a wavelength band having difficulty in oscillation. Therefore, in the semiconductor laser, there has been known a method for emitting the beam of the wavelength band having difficulty in oscillation by using a DPSS system (i.e., a diode-pumped solid-state laser).

It is difficult for the DPSS system to perform about 50-MHz high-speed modulation required by laser display use, for example. Accordingly, there has been proposed a laser system that converts a laser beam emitted from a semiconductor laser into a harmonic beam with a nonlinear optical element, and emits the converted harmonic beam (see Patent Document 1).

### PATENT DOCUMENT

Patent Document 1: Japanese Laid-open Patent Publication No. 06-132595

### SUMMARY OF THE INVENTION

### PROBLEM TO BE SOLVED BY THE INVENTION

In the laser system of Patent Document 1, if a conversion efficiency to harmonics in the nonlinear optical element is improved, a permissible wavelength range becomes narrow. The semiconductor laser and the nonlinear optical element have different wavelength temperature coefficients, respectively. The semiconductor laser and the nonlinear optical element also have variation in the wavelength characteristic for each element. Therefore, when the temperature of a laser module in which the semiconductor laser and the nonlinear optical element are mounted changes, for example, it is not easy to control the wavelength of the laser beam within a high efficient and convertible wavelength range.

There are a case where the temperature of the semiconductor laser locally changes and a case where the characteristic of the semiconductor laser itself changes. In this case, it is not easy to control the wavelength of the laser beam within the high efficient and convertible wavelength range based on the temperature of the laser module, and hence there is a case where the intensity of the harmonic beam lowers.

The present invention was devised in view of the above problems , and it is an object of the present invention to provide a laser system that can stably emit a harmonic beam.

### MEANS FOR SOLVING THE PROBLEM

The present invention is a laser system characterized by including: a laser module including: a laser that oscillates a laser beam; a heater that adjusts a temperature of the laser; and a harmonic generation element that converts the laser beam into a harmonic beam of the laser beam; and a control unit that modulates a wavelength of the laser beam, detects a detection signal synchronized with a modulation signal used for the modulation from an intensity of the harmonic beam, and controls a value of a heater current to be injected to the heater so as to reduce an amplitude of the detection signal. According to the present invention, the wavelength of the laser beam can be controlled in a range of wavelength that is convertible with the harmonic generation element, and the harmonic beam can be stably emitted from the harmonic generation element.

In the above-mentioned configuration, the control unit can be configured to reduce the amplitude of the detection signal by controlling the value of the heater current so as to reduce an absolute value of a difference between the values of the detection signal corresponding to the respective cases where the modulation signal is local maximum and local minimum.

In the above-mentioned configuration, the control unit can be configured to modulate the intensity of the laser beam and modulate the wavelength of the laser beam by a frequency higher than a frequency of intensity modulation of the laser beam. According to this configuration, even when the laser system is used for a laser display use or the like, for example, the wavelength of the laser beam can be controlled in the range of wavelength that is convertible with the harmonic generation element without being affected by a video. In addition, the wavelength of the laser beam can be quickly controlled in the range of wavelength that is convertible with the harmonic generation element, and a normal output state of the harmonic beam can be obtained more quickly.

In the above-mentioned configuration, when the intensity modulation of the laser beam is digitally modulated, the control unit can be configured to modulate the wavelength of the laser beam by a frequency higher than a sampling frequency of the intensity modulation.

In the above-mentioned configuration, the control unit can be configured to digitally modulate the intensity of the laser beam and modulate the wavelength of the laser beam using the modulation signal synchronized with sampling of the digital modulation. According to this configuration, a more appropriate detection signal can be obtained.

In the above-mentioned configuration, the control unit can be configured to modulate the intensity of the laser beam and modulate the wavelength of the laser beam by a frequency lower than a frequency of intensity modulation of the laser beam. According to this configuration, even when the laser system is used for a laser display use or the like, for example, the wavelength of the laser beam can be controlled in the range of wavelength that is convertible with the harmonic generation element without being affected by video data.

In the above-mentioned configuration, when the intensity of the intensity-modulated laser beam is smaller than a given threshold value, the control unit can be configured to avoid controlling the value of the heater current to be injected to the heater so as to reduce the amplitude of the detection signal. According to this configuration, it will suppress the possibility to adjust the laser wavelength with the outside of the range of wavelength that is convertible with the harmonic generation element.

In the above-mentioned configuration, the control unit can be configured to control the value of the heater current to be injected to the heater so as to reduce the amplitude of the detection signal while keeping the value of a driving current for driving the laser. According to this configuration, it is possible to facilitate a control for reducing the amplitude of the detection signal.

In the above-mentioned configuration, the laser system can be configured to include a storage unit that stores a table which associates the temperature of the laser module with a heater electric power to be injected to the heater, wherein the control unit periodically writes a new heater electric power in the table, based on the heater current controlled so as to reduce the amplitude of the detection signal, and injects a heater current to the heater with reference to the table when a power supply of the laser system is turned on. According to this configuration, when the power supply of the laser system is turned on, it is possible to easily and quickly match the wavelength of the laser beam with the range of wavelength that is convertible with the harmonic generation element.

In the above-mentioned configuration, when a difference between an initial value of the heater electric power prewritten in the table and a value of the heater electric power newly written in the table exceeds a given threshold value, the control unit can be configured to output an error. According to this configuration, it is possible to judge and exclude the laser module having a deteriorated characteristic.

### EFFECTS OF THE INVENTION

According to the present invention, the wavelength of the laser beam can be controlled in a range of wavelength that is convertible with the harmonic generation element, and the harmonic beam can be stably emitted from the harmonic generation element.

### BRIEF DESCRIPTION OF THE DRAWINGS

FIG. 1 is a block diagram illustrating an example of a laser system according to a first embodiment;
FIG. 2 is a schematic cross-section diagram illustrating an example of a DFB laser and a SOA:
FIG. 3 is a schematic diagram illustrating a relationship between a wavelength of a laser beam and a conversion efficiency of a harmonic generation element;
FIG. 4A is a schematic diagram illustrating a relationship between the wavelength of the laser beam and a driving current;
FIG. 4B is a schematic diagram illustrating a relationship between the wavelength of the laser beam and a heater electric power;
FIG. 5 is a flowchart illustrating an example of the control of a control unit in the laser system according to the first embodiment;
FIG. 6 is a schematic diagram illustrating an example of a modulation signal and a detection signal;
FIG. 7 is a schematic diagram illustrating an example of a relationship between the wavelength of the laser beam and the intensity of a harmonic beam, and a relationship between the wavelength of the laser beam and an error signal;
FIG. 8A is a schematic diagram illustrating an example of a table in an initial state;
FIG. 8B is a schematic diagram illustrating an example of the table after update;
FIG. 9 is a schematic diagram illustrating an example of a signal of a digital-intensity-modulated laser beam;
FIG. 10 is a schematic diagram illustrating an example of a relationship between the wavelength of the laser beam and the intensity of the harmonic beam at the beginning time of using of the laser system and a relationship between the wavelength of the laser beam and the intensity of the harmonic beam at the time of update of the table.

### EMBODIMENTS FOR CARRYING OUT THE INVENTION

A description will be given of embodiments of the invention, with reference to drawings.

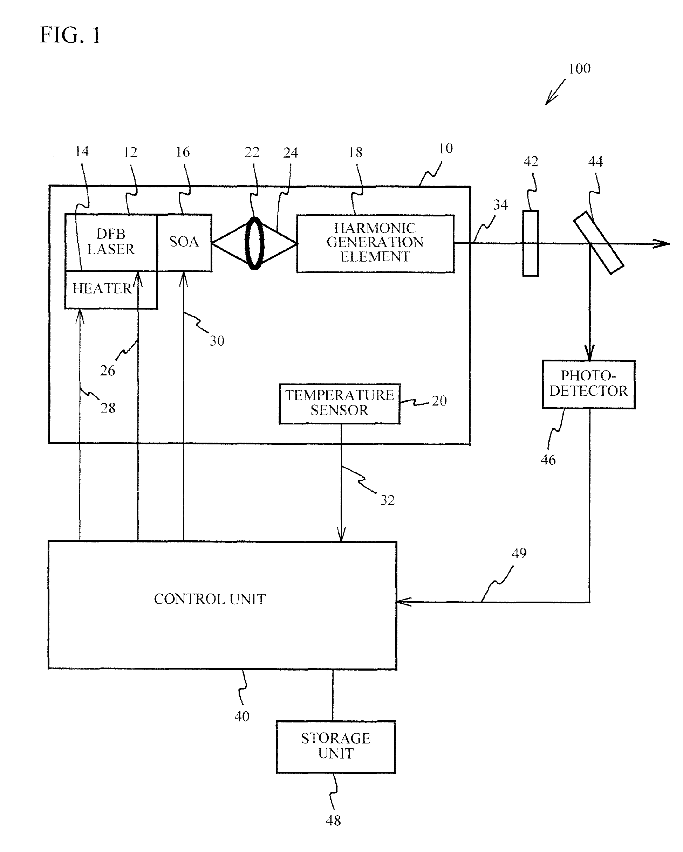

FIG. 1 is a block diagram illustrating an example of a laser system according to a first embodiment. As illustrated in FIG. 1, a laser system 100 according to the first embodiment includes a laser module 10, a control unit 40, an infrared light cut filter 42, a beam splitter 44, a photodetector 46, and a storage unit 48. The laser module 10 include a distributed feedback (DFB) laser 12, a heater 14, a semiconductor optical amplifier (SOA) 16, a harmonic generation element 18. a temperature sensor 20 and a lens 22. The SOA 16 and the harmonic generation element 18 are optically-coupled with each other via the lens 22. A laser beam 24 emitted from the SOA 16 enters into the harmonic generation element 18.

The DFB laser 12 is a laser which has a corrugation and oscillates the single-wavelength laser beam 24, e.g. the laser beam 24 having a wavelength of 1064 nm. The DFB laser 12 operates by a driving current 26 being injected by the control unit 40, and oscillates the laser beam 24. The heater 14 adjusts the temperature of the DFB laser by a heater current 28 being injected by the control unit 40. The SOA 16 modulates the intensity of the laser beam 24 by a voltage 30 being applied by the control unit 40. The SOA 16 changes the intensity of the laser beam 24, but does not change the wavelength of the laser beam 24. The DFB laser 12 and the SOA 16 are formed on the same chip, and optical axes of the DFB laser 12 and the SOA 16 are identical with each other. The temperature sensor 20 monitors the temperature of the laser module 10, and outputs a temperature monitor value 32 to the control unit 40.

The harmonic generation element 18 is an nonlinear optical element, and converts the incoming laser beam 24 into a harmonic beam 34. The harmonic generation element 18 is PPLN (Periodically Poled Lithium Niobate), for example, and emits the harmonic beam 34 having e.g. a 532 nm wavelength which is a second harmonic beam of the laser beam 24.

An infrared light cut filter 42 intercepts an infrared light among the beam emitted from the harmonic generation element 18, and passes only the harmonic beam 34. The beam splitter 44 branches a part of the harmonic beam 34 and enters the part of the harmonic beam 34 into the photodetector 46. The photodetector 46 monitors the intensity of the harmonic beam 34 and outputs an optical output monitor signal 49 to the control unit 40. The storage unit 48 is a nonvolatile memory, for example, and stores a table in which the temperature of the laser module 10 and a heater electric power to be supplied to the heater 14 are associated with each other. The control unit 40 controls the driving current 26 to be injected into the DFB laser 12, the heater current 28 to be injected into the heater 14, and the voltage 30 to be applied to the SOA 16.

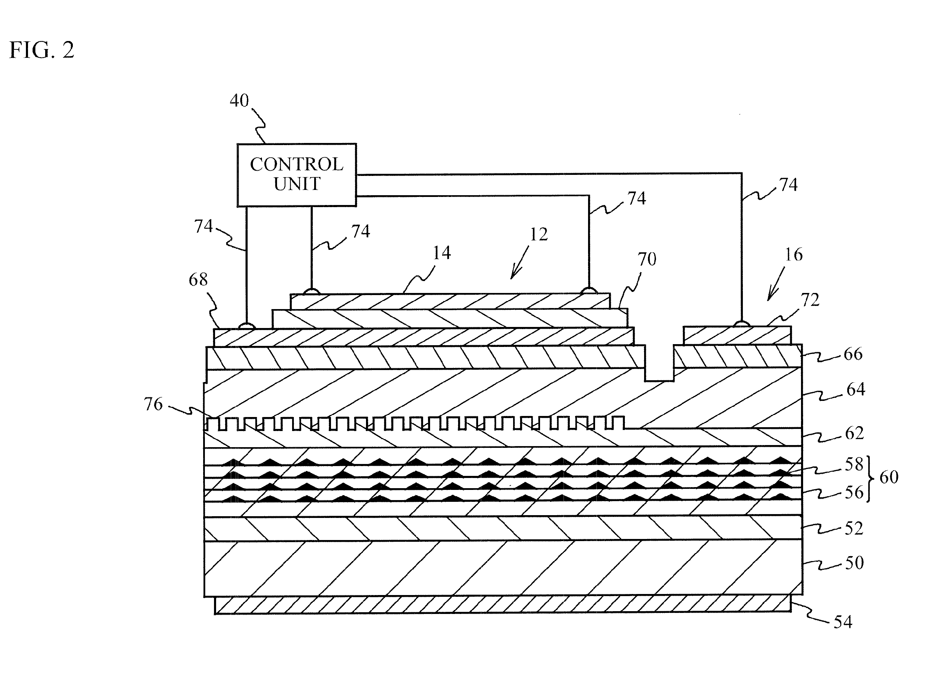

FIG. 2 is a schematic cross-section diagram illustrating an example of the DFB laser 12 and the SOA 16, An n-type cladding layer 52 made of n-type Al_{0.35}Ga_{0.65}As is formed on an n-type GaAs substrate 50. An electrode 54 is formed under the substrate 50. A quantum dot activity layer 60 including quantum dots 58 made of InAs in a base layer 56 made of GaAs is formed on the n-type cladding layer 52. A p-type layer 62 made of p-type GaAs is formed on the quantum dot activity layer 60. A p-type cladding layer 64 made of p-type InGaP is formed on the p-type layer 62. A corrugation 76 which decides the wavelength of the laser beam 24 to be emitted is formed between the p-type layer 62 and the p-type cladding layer 64 of the DFB laser 12. The elements from the substrate 50 to the p-type cladding layer 64 are common to the DFB laser 12 and the SOA 16.

Contact layers 66 made of p⁺GaAs are formed on the p-type cladding layer 64 of the DFB laser 12 and the SOA 16, respectively. In the DFB laser 12, an electrode 68 is formed on the contact layer 66. An insulating film 70 made of oxide silicon is formed on the electrode 68. The heater 14 made of e.g. Pt is formed on the insulating film 70. In the SOA 16, an electrode 72 is formed on the contact layer 66. The control unit 40 applies a voltage to the electrodes 68 and 72 and the heater 14 via the wires 74. The electrode 54 is connected to a given electric potential, e.g. is grounded.

The control unit 40 flows the driving current 26 between the electrode 68 and the electrode 54 by applying a voltage to the electrode 68 of the DFB laser 12. Thereby, stimulated emission occurs in the quantum dot activity layer 60, and the laser beam 24 propagates in the vicinity of the activity layer 60. Then, the control unit 40 controls the temperature of the DFB laser 12 by flowing the heater current 28 to the heater 14. In addition, the control unit 40 amplifies the laser beam 24 in the activity layer 60 by applying the voltage 30 between the electrodes 72 and 54. A value of the voltage between the electrodes 72 and 54 is changed, so that the amplification rate of the SOA 16 is changed. Therefore, the intensity of the laser beam 24 emitted from the SOA 16 can be modulated.

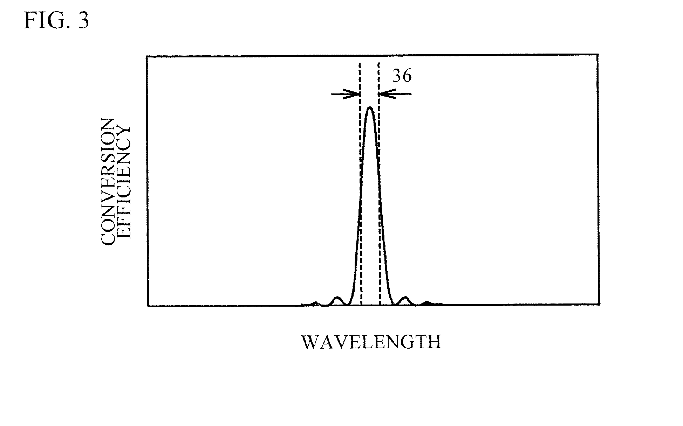

FIG. 3 is a schematic diagram illustrating a wavelength of the laser beam which the DFB laser 12 oscillates and a conversion efficiency of the harmonic generation element 18. If the conversion from a fundamental wave to the harmonic is performed by the harmonic generation element 18 with high conversion efficiency, as illustrated in FIG. 3, the permissible wavelength range turns into a narrow wavelength range like a domain 36. In the following description, a wavelength that can be converted from the fundamental wave to the harmonic with high conversion efficiency is called a phase matching wavelength of the harmonic generation element 18.

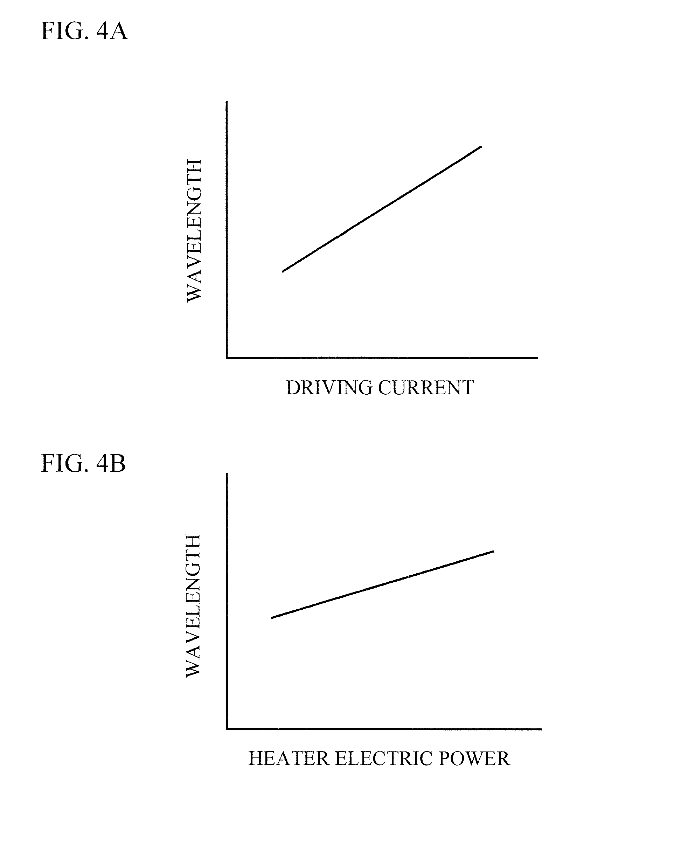

FIG. 4A is a schematic diagram illustrating a relationship between the wavelength of the laser beam which the DFB laser 12 oscillates, and the driving current of the DFB laser 12. FIG. 4B is a schematic diagram illustrating a relationship between the wavelength of the laser beam which the DFB laser 12 oscillates, and the heater electric power of the heater 14. The wavelength of the laser beam which the DFB laser 12 oscillates is shifted to a long wavelength side as the values of the driving current and the heater electric power increase, as illustrated in FIGs. 4A and 4B. That is, when the values of the driving current and the heater electric power change, the wavelength of the laser beam which the DFB laser 12 oscillates changes. Although the DFB laser 12 and the harmonic generation element 18 have different wavelength temperature coefficients, respectively, the wavelength of the laser beam which the DFB laser 12 oscillates can match the phase matching wavelength of the harmonic generation element 18, by controlling the values of the driving current and the heater electric power.

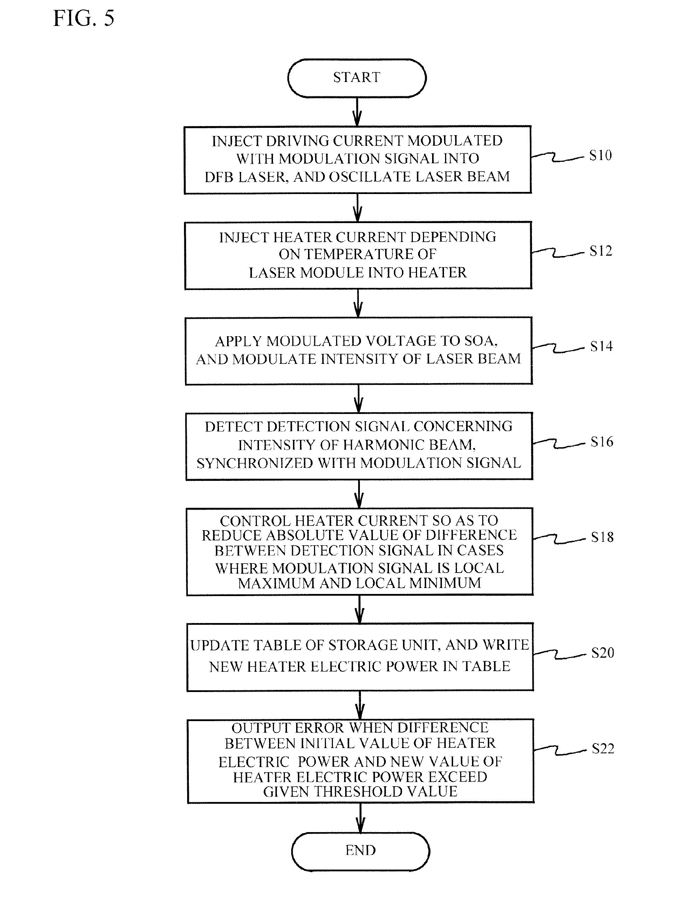

Next, a description will be given of an example of the control of the control unit 40 using a flowchart in FIG. 5. When a power supply of the laser system 100 is turned on as illustrated in FIG. 5, the control unit 40 injects the driving current 26 modulated with a modulation signal which is a tone signal, into the DFB laser 12, and oscillates the laser beam 24 (step S10). The value of a center of the modulated driving current 26 is turned into a predetermined value. By modulating the driving current 26, the wavelength of the laser beam 24 to be oscillated is modulated, as illustrated in FIG. 4A. The same frequency as a sampling frequency or a frequency higher than the sampling frequency in digital intensity modulation described later is used for a frequency of the modulation signal. For example, when the sampling frequency is 50 MHz, 50 MHz or 100 MHz is used as the frequency of the modulation signal. When the same frequency as the sampling frequency is used, it is desirable to synchronize the modulation of the wavelength with a control clock of the digital intensity modulation.

Next, the control unit 40 comprehends the temperature of the laser module 10 from the temperature monitor value 32 outputted by the temperature sensor 20. Then, the control unit 40 obtains the heater electric power corresponding to the temperature of the laser module 10 from the table stored into the storage unit 48, and injects the heater current 28 into the heater 14 (step S12). A corresponding relationship between the temperature of the laser module 10 and the heater electric power to be injected to the heater 14 is written in the table. That is, when the temperature of the laser module 10 is a certain temperature, data on the value of the heater electric power which can match the wavelength of the laser beam 24 with the phase matching wavelength of the harmonic generation element 18 is written in the table. As described above, since the DFB laser 12 and the harmonic generation element 18 have different wavelength temperature coefficients, respectively, a difference between the wavelength of the laser beam 24 which the DFB laser 12 oscillates, and the phase matching wavelength of the harmonic generation element 18 differs from another difference depending on the temperature of the laser module 10. As illustrated in FIG. 4B, the wavelength of the laser beam 24 can be changed by changing the value of the heater electric power. Therefore, the corresponding relationship between the temperature of the laser module 10 and the heater electric power to be injected to the heater 14 is written in the table in advance, and the value of the heater current 28 is controlled based on the temperature of the laser module 10 comprehended from the temperature monitor value 32 and the data written in the table, so that it is possible to match the wavelength of the laser beam 24 with the phase matching wavelength of the harmonic generation element 18. Thereby, the harmonic beam 34 can be emitted from the harmonic generation element 18.

Next, the control unit 40 applies the modulated voltage 30 to the SOA 16, and modulates the intensity of the laser beam 24 (step S14). The intensity modulation of the laser beam 24 is performed by the digital intensity modulation that 256 gradations are expressed, for example.

Next, the control unit 40 detects a detection signal synchronized with the frequency of the modulation signal which has modulated the driving current 26, from the intensity of the harmonic beam 34 detected with the photodetector 46 (step S16). The detection signal may be detected by extracting frequency component of the modulation signal from the intensity of the harmonic beam 34 detected with the photodetector 46, or by detecting the intensity of the harmonic beam 34 in synchronization with the frequency of the modulation signal by the photodetector 46. The control unit 40 calculates a difference between the values of the detection signal in the cases where the modulation signal is local maximum and adjacent local minimum, and controls the value of the heater current 28 to be injected to the heater 14 so as to reduce an absolute value of the difference (step S 18). When the value of the heater current 28 to be injected to the heater 14 is controlled, the control unit 40 keeps the value of the driving current 26 to be injected to the DFB laser 12 without changing it.

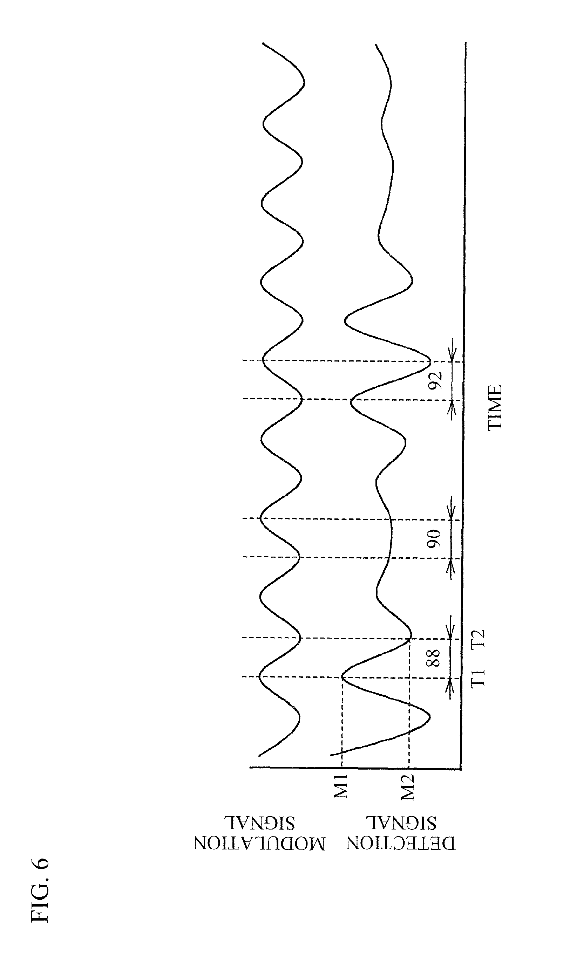

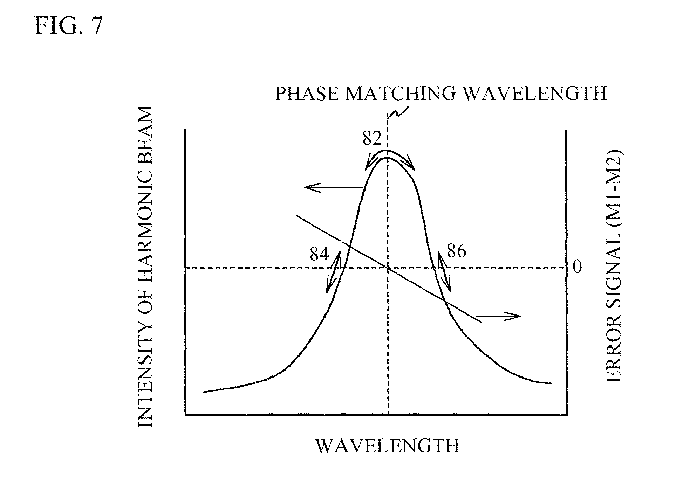

Here, a description will be given of the control described in steps S10 to S 18 of FIG. 5 using the schematic diagrams of FIGs. 6 and 7. Fig. 6 illustrates an example of the modulation signal used for the modulation of the driving current 26, and the detection signal synchronized with the modulation signal by making a horizontal axis into time. FIG. 7 illustrates an example of the intensity of the harmonic beam 34 with respect to the wavelength of the laser beam 24, and the difference (an error signal) between the values of the detection signal in the cases where the modulation signal is local maximum and adjacent local minimum with respect to the wavelength of the laser beam 24.

When the driving current 26 is modulated by using the modulation signal as illustrated in FIG. 6 and the wavelength of the laser beam 24 is modulated, the intensity of the harmonic beam 34 changes in a domain 82 of FIG. 7 if the central wavelength of the laser beam 24 matches the phase matching wavelength of the harmonic generation element 18. When the central wavelength of the laser beam 24 is shifted to a short wavelength side rather than the phase matching wavelength of the harmonic generation element 18, the intensity of the harmonic beam 34 changes in a domain 84 of FIG. 7, for example. When the central wavelength of the laser beam 24 is shifted to a long wavelength side rather than the phase matching wavelength of the harmonic generation element 18, the intensity of the harmonic beam 34 changes in a domain 86 of FIG. 7, for example.

Here, by the case where the temperature of the DFB laser 12 changes locally or the case where the characteristic of the DFB laser 12 itself changes, the case where the wavelength of the laser beam 24 is shifted to the short wavelength side rather than the phase matching wavelength of the harmonic generation element 18 is considered.
In this case, the value of the heater current 28 is controlled so that the wavelength of the laser beam 24 matches the phase matching wavelength of the harmonic generation element 18, and the wavelength of the laser beam 24 is changed between the short wavelength side and the long wavelength side of the harmonic generation element 18. The detection signal synchronized with the modulation signal is illustrated in FIG. 6, for example. In FIG. 6, an interval 88 corresponds to the detection signal in the region 84 of FIG. 7, an interval 90 corresponds to the detection signal in the region 82, and an interval 92 corresponds to the detection signal in the region 86.

When it is assumed that the difference (e.g. M1-M2) between the values of the detection signal in the cases where the modulation signal is local maximum and adjacent local minimum (e.g. time t1 and t2) is the error signal in FIG. 6, the error signal with respect to the wavelength of the laser beam 24 is illustrated in FIG. 7. Thereby, it turns out that the more the error signal approaches 0, the more the wavelength of the laser beam 24 approaches the phase matching wavelength of the harmonic generation element 18. That is, the smaller the absolute value of the difference between the values of the detection signal in the cases where the modulation signal is local maximum and adjacent local minimum is, the more the wavelength of the laser beam 24 matches the phase matching wavelength of the harmonic generation element 18. That is to say, the smaller the amplitude of the detection signal is, the more the wavelength of the laser beam 24 matches the phase matching wavelength of the harmonic generation element 18. Therefore, step S18 of FIG. 5 is performed, so that the wavelength of the laser beam 24 can match the phase matching wavelength of the harmonic generation element 18, and the harmonic beam 34 can be emitted from the harmonic generation element 18.

Returning to FIG. 5, the control unit 40 periodically updates the table stored into the storage unit 48, and writes a new heater electric power in the table based on the value of the heater current 28 controlled so that the wavelength of the laser beam 24 matches the phase matching wavelength of the harmonic generation element 18 in step S18 (step S20). Next, the control unit 40 calculates a difference between an initial value of the heater electric power prewritten into the storage unit 48 and the new heater electric power written in step S20. When the difference exceeds a given threshold value, the control unit 40 outputs an error indicating that the laser module 10 is abnormal (step S22).

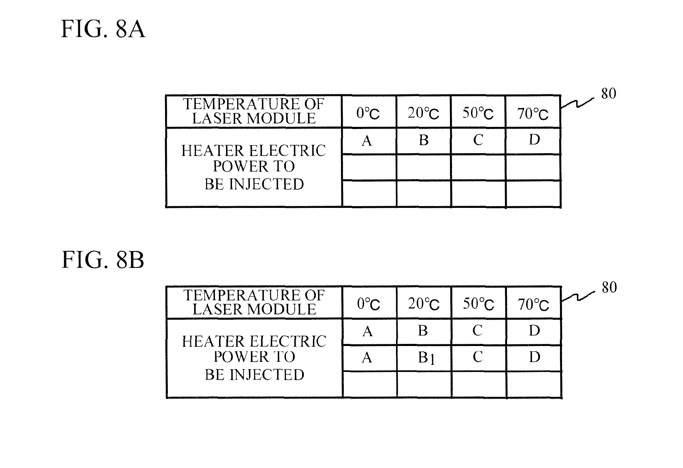

Here, a description will be given of a table 80 stored into the storage unit 48 using the schematic diagrams of FIGs. 8A and 8B. FIG. 8A illustrates an example of the table 80 in an initial state before a process of step S20 in FIG. 5 is performed. FIG. 8B illustrates an example of the table 80 after the process of step S20 in FIG. 5 is performed once, for example.

In the table 80 in the initial state, initial values A, B, C and D of the heater electric power corresponding to the case where the temperature of the laser module 10 is 0, 20, 50 and 70 degrees are prewritten, as illustrated in FIG. 8A. In the table 80 after the process of step S20 in FIG. 5 is performed once, a value B1 of the new heater electric power is written in a column of the heater electric power when the temperature of the laser module 10 is 20 degrees, for example, as illustrated in FIG. 8B. Thus, the new heater electric power is written in the table 80 based on the value of the heater current 28 controlled by the process of step S18 in FIG. 5. Therefore, when the difference between B1 and B exceeds the given threshold value, the control unit 40 outputs the error indicating that the laser module 10 is abnormal in step S22.

As described above, according to laser system 100 of the first embodiment, the control unit 40 modulates the driving current 26 that drives the DFB laser 12, and modulates the wavelength of the laser beam 24 which the DFB laser 12 oscillates. Then, the control unit 40 detects the detection signal synchronized with the modulation signal from the intensity of the harmonic beam 34 detected with the photodetector 46, and controls the value of the heater current 28 to be injected to the heater 14 so as to reduce the amplitude of the detection signal. For example, the control unit 40 controls the value of the heater current 28 to be injected to the heater 14 so that the absolute value of the difference between the values of the detection signal corresponding to the respective cases where the modulation signal is local maximum and adjacent local minimum reduces. Thereby, as illustrated in FIGs. 6 and 7, the wavelength of the laser beam 24 which the DFB laser 12 oscillates can be controlled in a range of wavelength that is convertible with the harmonic generation element 18, and the harmonic beam 34 can be stably emitted from the harmonic generation element 18.

The method that controls the value of the heater current 28 based on the temperature of the laser module 10 and controls the wavelength of the laser beam 24 in the range of wavelength that is convertible with the harmonic generation element 18 cannot deal with the case where the temperature of the laser module 10 does not change, such as the case where the temperature of the DFB laser 12 changes locally or the case where the characteristic of the DFB laser 12 itself changes. However, the laser system 100 of the first embodiment controls the wavelength of the laser beam 24 in the range of wavelength that is convertible with the harmonic generation element 18 by controlling the value of the heater current 28 using the intensity of the harmonic beam 34. Therefore, the laser system 100 can deal with the case where the temperature of the DFB laser 12 changes locally or the case where the characteristic of the DFB laser 12 itself changes, and can emits the harmonic beam 34 stably.

As described in step S18 of FIG. 5, when the value of the heater current 28 is controlled so as to reduce the amplitude of the detection signal, the value of the driving current 26 of the DFB laser 12 is kept without changing. When the driving current 26 of the DFB laser 12 is changed, the wavelength and the intensity of the laser beam 24 changes, and hence the control for making the amplitude of the detection signal small becomes complicated. Therefore, from points of view facilitating control to reduce the amplitude of the detection signal, it is desirable that the control unit 40 control the value of the heater current 28 to be injected to the heater 14 so as to reduce the amplitude of the detection signal while keeping the value of the driving current 26 that drives the DFB laser 12.

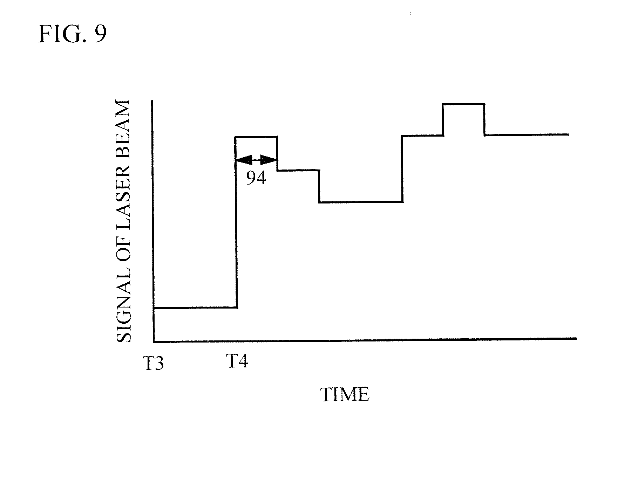

As described in step S 14 of FIG. 5, the control unit 40 performs the digital intensity modulation on the intensity of the laser beam 24. The control unit 40 modulates the driving current 26 using the modulation signal having a frequency higher than the sampling frequency of the digital intensity modulation, and modulates the wavelength of the laser beam 24. That is, the control unit 40 modulates the wavelength of the laser beam 24 using the frequency higher than the sampling frequency of the digital intensity modulation. FIG. 9 illustrates an example of a signal of a digital-intensity-modulated laser beam by making a horizontal axis into time.
The laser beam is intensity-modulated to 256 gradations, for example. When the wavelength of the laser beam 24 is modulated by the frequency higher than the sampling frequency of the digital intensity modulation, as illustrated in FIG. 9, the detection signal corresponding to the time of local maximum and local minimum of the modulation signal is acquired within a single pulse 94. Therefore, when the laser system 100 is used for a laser display use or the like, for example, the wavelength of the laser beam 24 can be controlled in the range of wavelength that is convertible with the harmonic generation element 18 without being affected by a video.

Also, when the wavelength of the laser beam 24 is modulated by the same frequency as the sampling frequency of the digital intensity modulation, it is desirable that the wavelength of the laser beam 24 is modulated using the modulation signal synchronized with the sampling of the digital modulation. In this case, a more suitable detection signal can be obtained.

In the first embodiment, the case where the intensity of the laser beam 24 is digital-modulated is described as an example, but the intensity of the laser beam 24 may be modulated by analog modulation. Even when the intensity of the laser beam 24 is modulated by any of the digital modulation or the analog modulation, the wavelength of the laser beam 24 is modulated by a frequency enough higher than the frequency of the intensity modulation of the laser beam 24. Thereby, when the laser system 100 is used for a laser display use or the like, for example, the wavelength of the laser beam 24 can be controlled in the range of wavelength that is convertible with the harmonic generation element 18 without being affected by a video.

In addition, the wavelength of the laser beam 24 is modulated by the frequency higher than the frequency of the intensity modulation of the laser beam 24, so that the wavelength of the laser beam 24 can be quickly controlled in the range of wavelength that is convertible with the harmonic generation element 18, and a normal output state of the harmonic beam 34 can be obtained more quickly.

When the intensity of the intensity-modulated laser beam 24 is smaller than the given threshold value, it is desirable that the control unit 40 does not control the value of the heater current 28 so as to reduce the difference of the detection signal, as described in step S18 of FIG. 5. For example, when the intensity of the laser beam 24 is digital-intensity-modulated to 256 gradations, if the intensity of the laser beam 24 is smaller than a given gradation value, the control unit 40 can avoid controlling the value of the heater current 28. For example, in FIG. 9, since the intensity of the laser beam 24 is smaller than the given gradation value from a time T3 to a time T4, the control unit 40 can avoid controlling the value of the heater current 28. Since the intensity of the laser beam 24 is larger than the given gradation value after time T4, the control unit 40 can control the value of the heater current 28.

When the intensity of the laser beam 24 is low and dark, the intensity of the harmonic beam 34 also is low and dark. In such a case, even when the wavelength of the laser beam 24 is shifted from the phase matching wavelength of the harmonic generation element 18, as illustrated in the regions 84 and 86 of FIG. 7, the difference between the values of the detection signal corresponding to the time of local maximum and local minimum of the modulation signal becomes small. Therefore, it is difficult to control the value of the heater current 28 so as to match the wavelength of the laser beam 24 with the phase matching wavelength of the harmonic generation element 18, and the case where the wavelength of the laser beam 24 is matched with a position shifted from the phase matching wavelength of the harmonic generation element 18 may occur. Accordingly, when the intensity of the intensity-modulated laser beam 24 is smaller than the given threshold value, it is desirable that the control unit 40 does not control the value of the heater current 28 so as to reduce the amplitude of the detection signal. Thereby, it is possible to suppress matching the wavelength of the laser beam 24 with the outside of the range of wavelength that is convertible with the harmonic generation element 18. The judgment of whether the intensity of the intensity-modulated laser beam 24 is smaller than the given threshold value may be judged by whether a voltage value to be applied to the SOA 16 is smaller than a given threshold value, or whether the intensity of the harmonic beam 34 detected with the photodetector 46 is smaller than a given threshold value, except for the above-mentioned judgment. The given threshold value means a value of the degree that it is difficult to match the wavelength of the laser beam 24 with the range of wavelength that is convertible with the harmonic generation element 18, as described above. For example, about 1/10 of the maximum detection intensity can be set up as the threshold value.

As illustrated in FIG. 1, there is the storage unit 48 that stores the table 80 which associates the temperature of the laser module 10 with the heater electric power to be injected to the heater 14. Then, the control unit 40 periodically writes the new heater electric power in the table 80, based on the value of the heater current 28 controlled so as to reduce the amplitude of the detection signal, as described in step 20 of FIG. 5. When the power supply of the laser system 100 is turned on, the control unit 40 calculates the heater electric power corresponding to the temperature of the present laser module 10 with reference to the table 80 stored into the storage unit 48, and injects the heater current 28 into the heater 14, as described in step S12 of FIG. 5. Thereby, when the power supply of the laser system 100 is turned on, it is possible to easily and quickly match the wavelength of the laser beam 24 which the DFB laser 12 oscillates, with the range of wavelength that is convertible with the harmonic generation element 18.

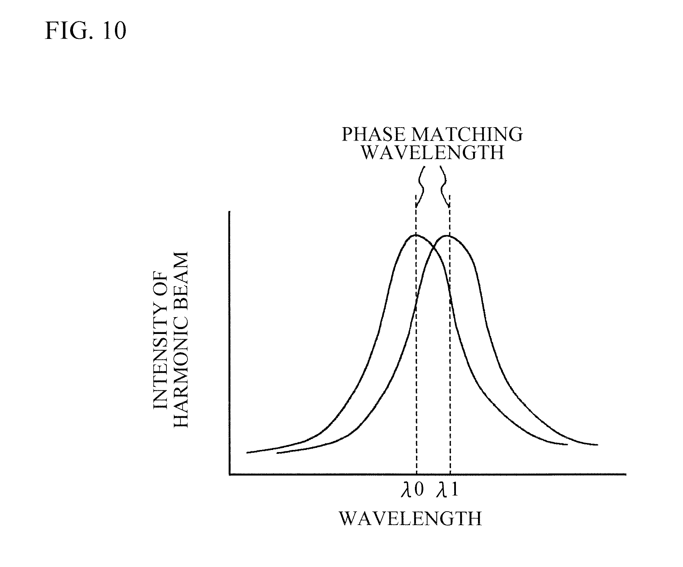

The control unit 40 calculates the difference between the initial value of the heater electric power prewritten in the table 80 stored into the storage unit 48 and the value of the new written heater electric power, and outputs the error when the difference exceeds the given threshold value, as described in step S22 of FIG. 5.
Since the wavelength of the laser beam 24 changes depending on the value of the heater electric power as described in FIG. 4B, the change of the value of the heater electric power means that the wavelength of the laser beam 24 has changed. FIG. 10 illustrates examples of a relationship between the wavelength of the laser beam 24 and the intensity of the harmonic beam 34 at the beginning time of using of the laser system 100 and a relationship between the wavelength of the laser beam 24 and the intensity of the harmonic beam 34 when the table 80 is updated and a new value of the heater electric power is written. It is assumed that, as illustrated in FIG. 10, the wavelength of the laser beam 24 matches the phase matching wavelength of the harmonic generation element 18 at λ0, for example, at the beginning time of using, and the wavelength of the laser beam 24 matches the phase matching wavelength of the harmonic generation element 18 at λ1, for example, when the table 80 is updated. In this case, it is considered that the characteristic of the laser module 10 has changed. Therefore, it is desirable that, when the difference between the initial value of the heater electric power and the new written value of the heater electric power exceeds the given threshold value, the control unit 40 considers that the characteristic of the laser module 10 has changed, and outputs the error. Thereby, it is possible to judge and exclude the laser module 10 having a deteriorated characteristic. The given threshold value means a value of the degree that it can be considered that the characteristic of the laser module 10 has changed. For example, a value shifted 10% with respect to a maximum injection electric power to the heater 14 can be set as the threshold value.

In the first embodiment, to modulate the wavelength of the laser beam 24 which the DFB laser 12 oscillates, the case where the driving current 26 to be injected to the DFB laser 12 is modulated is described as one example. However, the first embodiment is not limited to this. The wavelength of the laser beam 24 may be modulated by another method, such as a case where the heater current 28 to be injected to the heater 14 is modulated. When the heater current 28 is modulated, there is an advantage which can make the intensity of the laser beam 24 which the DFB laser 12 oscillates constant. On the other hand, when the driving current 26 is modulated, there is an advantage that a response characteristic is excellent. Therefore, when the wavelength of the laser beam 24 is modulated at high speed like a frequency higher than the sampling frequency of the digital intensity modulation, for example, it is desirable that the driving current 26 is modulated.

Moreover, in the first embodiment, a case where the intensity of the laser beam 24 is modulated by the frequency higher than the frequency of intensity modulation of the laser beam 24 is described as one example, such as a case where the wavelength of the laser beam 24 is modulated by the frequency higher than the sampling frequency of the digital intensity modulation. However, the first embodiment is not limited to this. For example, the wavelength of the laser beam 24 may be modulated by a frequency enough lower than the frequency of the intensity modulation of the laser beam 24. For example, when the intensity modulation of the laser beam 24 is performed at 50 MHz, the modulation of the wavelength of the laser beam 24 can be performed at 1 kHz. Thus, even if the wavelength of the laser beam 24 is modulated by the frequency enough lower than the frequency of the intensity modulation of the laser beam 24, when the laser system 100 is used for a laser display use or the like, for example, the wavelength of the laser beam 24 can be controlled in the range of wavelength that is convertible with the harmonic generation element 18 without being affected by a video.

Although in the first embodiment, a case where the laser is a quantum dot DFB laser is described as one example, the laser is not limited to this. For example, the laser may be a quantum well DFB laser or the like, and the laser may be a Fabry-Perot type laser other than the DFB laser. In addition, although a case where the SOA 16 and the harmonic generation element 18 are optically coupled via the lens 22 is described as one example, the SOA 16 and the harmonic generation element 18 may be coupled directly.

Although in the first embodiment, the example in which the harmonic generation element 18 converts the laser beam 24 into a second harmonic of the laser beam 24 is explained, the harmonic generation element 18 may convert the laser beam 24 into a high order harmonic beam of the laser beam 24. Then, although the case where the laser beam 24 is 1064 nm and the harmonic beam 34 is the green beam of 532 nm is explained as one example, the harmonic beam 34 may be a beam having another wavelength. In addition, the laser beam 24 may have another wavelength.

Although the desirable embodiments of the present invention has been described in detail, the present invention is not limited to a certain embodiment, and it should be understood that the various change, substitutions, and alterations could be made hereto without departing from the spirit and scope of the invention.

## Claims

1. A laser system, **characterized by** comprising:
a laser module including:
a laser that oscillates a laser beam;
a heater that adjusts a temperature of the laser; and
a harmonic generation element that converts the laser beam into a harmonic beam of the laser beam; and
a control unit that modulates a wavelength of the laser beam, detects a detection signal synchronized with a modulation signal used for the modulation from an intensity of the harmonic beam, and controls a value of a heater current to be injected to the heater so as to reduce an amplitude of the detection signal.

2. The laser system as claimed in claim 1, **characterized in that** the control unit reduces the amplitude of the detection signal by controlling the value of the heater current so as to reduce an absolute value of a difference between values of the detection signal corresponding to the respective cases where the modulation signal is local maximum and local minimum.

3. The laser system as claimed in claim 1 or 2, **characterized in that** the control unit modulates the intensity of the laser beam and modulates the wavelength of the laser beam by a frequency higher than a frequency of intensity modulation of the laser beam.

4. The laser system as claimed in claim 3, **characterized in that**, when the intensity modulation of the laser beam is digitally modulated, the control unit modulates the wavelength of the laser beam by a frequency higher than a sampling frequency of the intensity modulation.

5. The laser system as claimed in claim 1 or 2, **characterized in that** the control unit digitally modulates the intensity of the laser beam and modulates the wavelength of the laser beam using the modulation signal synchronized with sampling of the digital modulation.

6. The laser system as claimed in claim 1 or 2, **characterized in that** the control unit modulates the intensity of the laser beam and modulates the wavelength of the laser beam by a frequency lower than a frequency of intensity modulation of the laser beam.

7. The laser system as claimed in any one of claims 3 to 6, **characterized in that**, when the intensity of the intensity-modulated laser beam is smaller than a given threshold value, the control unit avoids controlling the value of the heater current to be injected to the heater so as to reduce the amplitude of the detection signal.

8. The laser system as claimed in any one of claims 1 to 7, **characterized in that** the control unit controls the value of the heater current to be injected to the heater so as to reduce the amplitude of the detection signal while keeping the value of a driving current for driving the laser.

9. The laser system as claimed in any one of claims 1 to 8, **characterized by** comprising:
a storage unit that stores a table which associates the temperature of the laser module with a heater electric power to be injected to the heater;
wherein the control unit periodically writes a new heater electric power in the table, based on the heater current controlled so as to reduce the amplitude of the detection signal, and injects a heater current to the heater with reference to the table when a power supply of the laser system is turned on.

10. The laser system as claimed in claim 9, **characterized in that**, when a difference between an initial value of the heater electric power prewritten in the table and a value of the heater electric power newly written in the table exceeds a given threshold value, the control unit outputs an error.
